# EUROPÄISCHE PATENTSCHRIFT

(11) **EP 0 524 331 B1**
(45) Veröffentlichungstag und Bekanntmachung des Hinweises auf die Patenterteilung: **06.07.1994**
(21) Anmeldenummer: 91112280.2
(22) Anmeldetag: 22.07.1991
(51) Int. Cl.: B23K 1/00, B23K 3/047

(54) **Lötverfahren**
Soldering procedure
Procédé de brasage tendre

(43) Veröffentlichungstag der Anmeldung: 27.01.1993
(73) Patentinhaber: Siemens Solar GmbH, 80807 München (DE)
(72) Erfinder: Holdermann, Konstantin, Dipl.-Chem., W-8875 Offingen (DE); Münzer, Adolf, Dipl.-Phys., W-8000 München 80 (DE); Riermeier, Manfred, W-8059 Oberneuching (DE); Schuber, Viktor, W-8011 Kirchheim (DE); Zinke, Gerhard, Dipl.-Phys., W-8000 München 81 (DE)
(74) Vertreter: Fuchs, Franz-Josef, Dr.-Ing.

(56) Entgegenhaltungen:
- EP-A- 0 002 550
- US-A- 3 015 713
- IBM TECHNICAL DISCLOSURE BULLETIN Bd. 32, Nr. 10B, März 1990, ARMONK, NY, USASeiten 456 - 457; 'COMPLIANT THERMODE FOR SURFACE SOLDER'
- E. LÜDER 'HANDBUCH DER LÖTTECHNIK' 1952 , VERLAG TECHNIK BERLIN , BERLIN, DE

## Beschreibung

Bei bestimmten Lötproblemen wird ein Lötverfahren angewandt, bei welchem das Lot in Form einer Lotpaste auf dem zu verlötenden Werkstück bereitgestellt wird. Die Lotpaste besteht aus einem Flußmittel enthaltenden Bindemittel, in welches die Lotpartikel in Form kleiner Kügelchen eindispergiert sind. Der anschließende Lötprozeß kann ein Reflow-Prozeß oder ein Direktlöten sein.

Der Reflow-Prozeß besteht aus zwei Prozeßschritten. Zunächst erfolgt ein Aufschmelzen der Lotpaste und gegebenenfalls eine Reinigung des Werkstückes und anschließend im zweiten Prozeßschritt die Verbindungslötung mit einem DRaht, Bändchen oder ähnlichem Werkstück.

Beim Reflow-Verfahren gibt es verschiedene Methoden, die Lotpartikel aufzuschmelzen. Diese unterscheiden sich hauptsächlich in der Art der Wärmezuführung zum Lot. Bei Verfahren, bei denen die benötigte Wärme über ein heißes flüssiges oder dampfförmiges Medium übertragen wird, kommt es jedoch zu einer relativ hohen thermischen Belastung des gesamten Werkstückes. Für thermisch empfindliche Werkstücke wird deshalb oft ein Lötverfahren bevorzugt, bei dem die Lotpaste durch direkten Kontakt mit einem heißen Lötkopf aufgeschmolzen wird. So ist es möglich, gerade eben die erforderliche Wärmemenge zu übertragen und das Werkstück nur punktuell an den vorgehenden Lötstellen thermisch zu belasten.

Auch beim Direktlötverfahren, bei dem das Aufschmelzen des Lotes und die Verbindungslötung in einem Prozeßschritt stattfinden, hat dieses Kontaktverfahren die zuvor genannten Vorteile.

Doch auch diese Lötverfahren mit mechanischem Kontakt besitzen erhebliche Nachteile. Durch den erforderlichen innigen Kontakt des Lötkopfes mit der Lotpaste kommt es zu einer erheblichen Verschmutzung des Lötkopfes, insbesondere durch Verkrustung von Flug- bzw. Bindemittelrückständen aus der Lotpaste. Diese Verschmutzungen behindern die Wärmeübertragung vom Lötkopf auf die Lotpaste und erzeugen auf dem Lötkopf ein unerwünschtes und unregelmäßiges Profil.

Aus IBM Technical Disclosure Bulletin Band 32, No. 10B, März 1990, Seiten 456 bis 457 ist ein Direktlötverfahren bekannt, mit dem ein flexibles Band auf einer unebenen Oberfläche aufgelötet werden kann.

Aufgabe der vorliegenden Erfindung ist es daher, ein Lötverfahren anzugeben, bei dem die thermische Belastung des zu verlötenden Werkstückes gering ist, welches einfach durchzuführen und welches außerdem für hochautomatisierte Prozesse geeignet ist und mit dem ein Lotkontaktfleck mit glatter Oberfläche erzeugt werden kann.

Diese Aufgabe wird erfindungsgemäß gelöst durch ein Lötverfahren mit den Merkmalen von Anspruch 1.

Weitere Ausgestaltungen der Erfindung sind den Unteransprüchen zu entnehmen.

Die Folie mit eine gute Wärmeübertragung gewährleisten und daher insbesondere dünn ausgebildet sein. Bei entsprechender Auswahl des Folienmaterials bleibt kein Lot an der Folie kleben, so daß diese auch nicht an der Lötstelle klebt.

Aus der US-A-3 015 713 ist ein Elektroschweißverfahren bekannt, welches bereits eine dünne Metallfolie zur Verhinderung der Oxidation der Schweißelektrode benutzt.

Mit dem erfindungsgemäßen Verfahren dagegen wird eine Verschmutzung der Lötelektrode (Lötkopf) durch die Lotpaste bzw. dessen Bindemittel oder Flußmittel total vermieden. Dadurch wird ein kontinuierliches Löten ohne häufige Reinigungspausen für den Lötkopf möglich.

Für die Trennfolie ist am besten eine Metallfolie geeignet, zum Beispiel eine Aluminiumfolie. Diese läßt sich ausreichend dünn herstellen, zeigt dabei eine hohe mechanische Festigkeit und läßt sich nicht mit Lot benetzen, bzw. bleibt nicht an diesem kleben.

In vorteilhafter Weise wird eine streifenförmige Trennfolie beim erfindungsgemäßen Verfahren verwendet, welche eine dem Lötkopf bzw. der Lötstelle entsprechende Breite aufweist. Zwischen zwei Lötvorgängen wird die Folie unter dem Lötkopf um ein solches Stück durchgezogen, daß sich oberhalb der Lötstelle gerade eben "frische" Folie befindet. Auf diese Weise wird vermieden, daß Rückstände des Flußmittels und des Bindemittels die nachfolgende Lötung negativ beeinflussen, und es wird zudem äußerst wenig Folie verbraucht, so daß das Verfahren insgesamt kostengünstig ist.

Eine besonders vorteilhafte Anwendung findet das Verfahren bei Verwendung von Lotpasten mit wasserlöslichem Flußmittel. Dieses neigt besonders zur Verharzung und wäre ist bei herkömmlichen Kontaktlötverfahren vom Lötkopf besonders schwierig zu entfernen.

Einen weiteren Vorteil bietet das Verfahren bei der Herstellung eines Lötkontaktflecks. Durch die Trennfolie läßt sich dieser Lotkontaktfleck äußerst dünn und mit glatter Oberfläche herstellen, so daß er eine gute Haftung auf dem Werkstück aufweist und aufgrund der ebenen Oberfläche leicht vom Flußmittel zu reinigen und ebenso leicht weiterzuverarbeiten ist. In jedem Fall ist ein Lotkontaktfleck einfacher zu reinigen als eine Lötverbindung, welche oft schwer zugängliche Abschattungen durch das aufgelötete Teil zeigt. Wenn beim Verlöten ein größerer Verbund entsteht, sind die Einzelteile nach Erzeugung des Lotkontaktflecks und vor dem Verlöten einfacher zu reinigen als der verlötete Verbund.

Die glatte Oberfläche des Lotkontaktflecks ermöglicht eine gute und schnelle Wärmeübertragung beim eigentlichen Verlöten, so daß dieses ebenfalls schnell bei geringstmöglicher thermischer Belastung des Werkstücks erfolgen kann.

Im folgenden wird die Erfindung anhand eines Ausführungsbeispiels und der dazugehörigen drei Figuren näher erläutert. Die Figuren zeigen im schematischen Querschnitt drei Verfahrensstufen bei der Herstellung eines Lotkontaktflecks gemäß dem erfindungsgemäßen Verfahren.

Es wird die Herstellung eines Lotkontaktflecks (Belotung) auf einer Siliziumsolarzelle zum Anlöten eines Verbindungsbandes zur elektrischen Verschaltung mehrerer Solarzellen untereinander beschrieben.

Auf der Oberfläche (bzw. Rückseite) der Siliziumsolarzelle ist eine Solarzellenmetallkontaktschicht aufgebracht, an der Lichteinfallsseite zum Beispiel in Form eines fingerförmigen Grid. Die Solarzellenmetallkontaktschicht besteht aus einer eingebrannten, silberhaltigen Paste, die einen guten Kontakt auf der Siliziumoberfläche besitzt. An den vorgesehenen Lötstellen wird nun mit einem Schablonendruckverfahren eine Lotpaste aufgebracht, zum Beispiel ein Zinn/Silberlot mit einem wasserlöslichen Flußmittel.

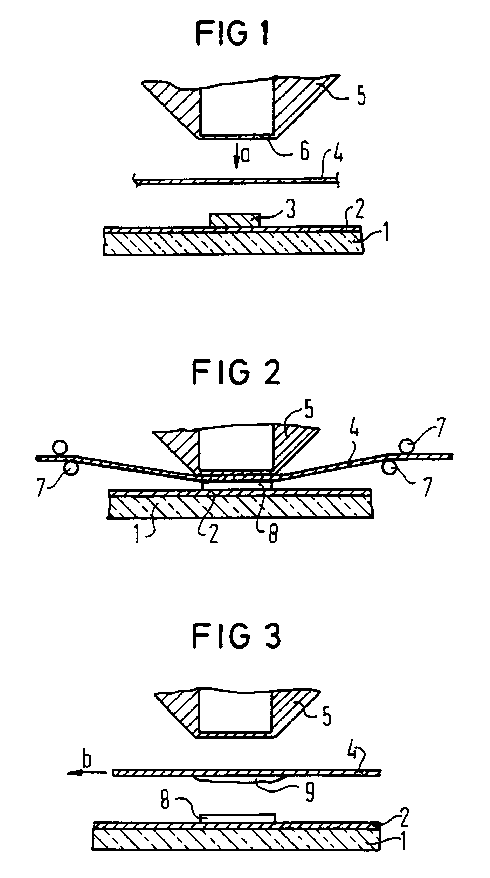

Figur 1 zeigt den so vorbereiteten Siliziumkörper 1 mit der Metallkontaktschicht 2 und der zum Beispiel aufgedruckten Lotpaste 3. Der Siliziumkörper 1 (Solarzelle) wird nun in einer Lötvorrichtung so angeordnet, daß der Lötkopf 5 (Bügelelektrode) über der Lotpaste 3 auf der Solarzelle angeordnet ist, wobei zwischen Lötkopf 5 und der Lotpaste 3 eine Trennfolie 4 (Aluminiumfolie) geführt wird.

Durch Absenken des Lötkopfes 5 in Richtung Solarzelle (siehe Richtungspfeil a) drückt dieser die Trennfolie 4 gegen die Lotpaste 3, wie es in Figur 2 dargestellt ist. Mit Bezugszeichen 7 sind Umlenkrollen zur Führung der zum Beispiel streifenförmigen Trennfolie 4 angedeutet. Durch einen kurzen Stromimpuls heizt sich der Lötkopf im dünnen Bereich 6 auf, überträgt die Wärme durch die Trennfolie 4 auf die Lotpaste 3 und bringt diese zum Aufschmelzen, wobei durch den Druck des Lötkopfes 5 ein verbreiterter Lotkontaktfleck 8 entsteht.

Figur 3 zeigt die Anordnung nach dem Hochfahren des Lötkopfes 5. Der Lotkontaktfleck 8 weist eine ebene und glatte Oberfläche auf, die ebenso wie die darüberliegende Trennfolie im Bereich 9 noch vom ebenfalls aufgeschmolzenen Flußmittel benetzt bzw. verschmutzt ist. Für den nächsten Verfahrensschritt wird nun die Folie 4 in Richtung b um den Bereich der Verschmutzung 9 gegenüber dem Lötkopf 5 verschoben. Für einen weiteren Lötvorgang auf demselben oder auf einem anderen Werkstück (Solarzelle) steht nun ein frischer bzw. nicht verschmutzter Bereich der Trennfolie 4 zur Verfügung.

Das beschriebene Verfahren ist insbesondere für die Verlötung von Kontaktbändern auf Solarzellen geeignet, da andere Lötverfahren zu einem Ablegieren der Silberkontaktschicht 2 auf dem Siliziumkörper 1 in das Lot führen. Dabei geht die gute Haftung der Silberkontaktschicht 2 auf dem Siliziumkörper 1 verloren, was zu einem Ablösen der Lötstelle bzw. der Verlötung führen kann. Nur mit dem angegebenen Kontaktlötverfahren mittels einer Lotpaste läßt sich ein so kurzer thermischer Impuls erzeugen, daß es noch zu keinem Auflegieren der Silberkontaktschicht 2 kommt. Eine weitere Verminderung der thermischen Belastung der Lötstelle läßt sich durch einen kühlbaren Lötkopf 5 erzielen, wobei nach dem Aufschmelzen der Lotpaste 3 die überschüssige Wärme über den dann gekühlten Lötkopf wieder abgeführt wird.

Nach der Herstellung des Lotkontaktflecks 8 bzw. der einstufigen Verlötung eines Teils auf dem Werkstück wird dieses von dem Flußmittel gereinigt. Die Verwendung einer Lotpaste mit wasserlöslichem Flußmittel ermöglicht die Durchführung der Reinigung in reinem Wasser unter Verzicht auf organische Lösungsmittel, insbesondere auf die bislang üblichen halogenierten Kohlenwasserstoffe. Somit ist das erfindungsgemäße Lötverfahren völlig umweltfreundlich, weil es auf schädliche und schwer abbaubare Lösungsmittel verzichtet.

## Patentansprüche

1. Lötverfahren mit den Schritten
- Aufbringen einer Lotpaste (3) an vorgesehenen Lötstellen auf einem Werkstück
- Inkontaktbringen der Lotpaste (3) mit einem Lötkopf (5) und Aufschmelzen der Lotpaste (3), wobei eine zwischen Lötkopf (5) und Lotpaste (3) qeführte Trennfolie (4) den direkten Kontakt des Lötkopfes mit der Lotpaste verhindert
- Abheben des Lötkopfes (5) und der Trennfolie (4) von der Lötstelle, wobei ein Lotkontaktfleck (8) mit glatter Oberfläche verbleibt und
- Vorbeiführen der Trennfolie (4) um ein der Größe der Lötstelle entsprechendes Stück vor dem nächsten Lötvorgang.

2. Verfahren nach Anspruch 1,
bei dem als Trennfolie (4) eine Metallfolie verwendet wird.

3. Verfahren nach Anspruch 2,
bei dem als Trennfolie (4) eine Aluminiumfolie verwendet wird.

4. Verfahren nach einem der Ansprüche 1 bis 3,
bei dem die verwendete Lotpaste (3) ein wasserlösliches Flußmittel enthält.

5. Verfahren nach einem der Ansprüche 1 bis 4,
bei dem eine streifenförmige Trennfolie (4) verwendet wird.

6. Verfahren nach einem der Ansprüche 1 bis 5,
bei dem das Werkstück (1) vor der eigentlichen Verlötung von Flußmittel gereinigt wird.

7. Verfahren nach einem der Ansprüche 1 bis 6,
bei dem die Lotpaste (3) mittels Sieb- oder Schablonendruck auf dem Werkstück (1) aufgebracht wird.

8. Verwendung des Verfahrens nach einem der Ansprüche 1 bis 7 zum Beloten von Solarzellen aus Silizium.

## Claims

1. Soldering method comprising the steps
- application of a solder paste (3) to provided soldering points on a workpiece
- bringing the solder paste (3) into contact with a soldering head (5) and melting the solder paste (3), a separating foil (4) which is passed between the soldering head (5) and the solder paste (3) preventing direct contact of the soldering head with the solder paste
- lifting off the soldering head (5) and the separating foil (4) from the soldering point, a solder contact spot (8) having a smooth surface remaining, and
- feeding the separating foil (4) on by an amount corresponding to the size of the solder point, for the next soldering process.

2. Method according to Claim 1, in the case of which a metal foil is used as the separating foil (4).

3. Method according to Claim 2, in the case of which an aluminium foil is used as the separating foil (4).

4. Method according to one of Claims 1 to 3, in the case of which the solder paste (3) which is used contains a water-soluble flux.

5. Method according to one of Claims 1 to 4, in the case of which a separating foil (4) in the form of strips is used.

6. Method according to one of Claims 1 to 5, in the case of which the workpiece (1) is cleaned of flux before the actual soldering.

7. Method according to one of Claims 1 to 6, in the case of which the solder paste (3) is applied on the workpiece (1) by means of silk-screen printing or screen printing.

8. Use of the method according to one of Claims 1 to 7 for the soldering of solar cells made of silicone.

## Revendications

1. Procédé de brasure comprenant les stades
- de dépôt d'une pâte (3) de brasure en des points prévus sur une pièce,
- de mise en contact de la pâte (3) de brasure avec une tête (5) de brasure et d'application de la pâte (3) de brasure par fusion, une feuille (4) de séparation interposée entre la tête (5) de brasure et la pâte (3) de brasure empêchant le contact direct de la tête de brasure avec la pâte de brasure,
- de soulèvement de la tête (5) de brasure et de la feuille (4) de séparation du point de brasure en laissant subsister une tâche (8) de contact de brasure de surface lisse, et
- d'avancement de la feuille (4) de séparation d'une distance correspondant à la dimension du point de brasure avant l'opération de brasure suivante.

2. Procédé suivant la revendication 1,
qui consiste à utiliser comme feuille (4) de séparation une feuille métallique.

3. Procédé suivant la revendication 2,
qui consiste à utiliser comme feuille (4) de séparation une feuille d'aluminium.

4. Procédé suivant l'une des revendications 1 à 3,
dans lequel la pâte (3) de brasure qui est utilisée contient un flux hydrosoluble.

5. Procédé suivant l'une des revendications 1 à 4,
qui consiste à utiliser une feuille (4) de séparation en forme de bande.

6. Procédé suivant l'une des revendications 1 à 5,
qui consiste à débarrasser la pièce (1) du flux avant la brasure proprement dite.

7. Procédé suivant l'une des revendications 1 à 6,
qui consiste à déposer la pâte (3) de brasure sur la pièce (1) par sérigraphie.

8. Utilisation du procédé suivant l'une des revendications 1 à 7 pour braser des piles solaires en silicium.
